(19) Europäisches Patentamt
European Patent Office
Office européen des brevets

(11) **EP 4 660 865 A1**

(12) **EUROPÄISCHE PATENTANMELDUNG**

(43) Veröffentlichungstag:
**10.12.2025  Patentblatt 2025/50**

(21) Anmeldenummer: **24180785.8**

(22) Anmeldetag: **07.06.2024**

(51) Internationale Patentklassifikation (IPC):
**G06F 30/13** *(2020.01)*

(52) Gemeinsame Patentklassifikation (CPC):
**G06F 30/13**

(84) Benannte Vertragsstaaten:
**AL AT BE BG CH CY CZ DE DK EE ES FI FR GB GR HR HU IE IS IT LI LT LU LV MC ME MK MT NL NO PL PT RO RS SE SI SK SM TR**
Benannte Erstreckungsstaaten:
**BA**
Benannte Validierungsstaaten:
**GE KH MA MD TN**

(71) Anmelder: **Fraunhofer-Gesellschaft zur Förderung**
**der angewandten Forschung e.V.**
**80686 München (DE)**

(72) Erfinder: **Dr. MAURER, Christoph**
**79110 Freiburg (DE)**

(74) Vertreter: **LBP Lemcke, Brommer & Partner**
**Patentanwälte mbB**
**Siegfried-Kühn-Straße 4**
**76135 Karlsruhe (DE)**

(54) **VERFAHREN ZUR AUSWAHL EINES SOLARELEMENTMODELLS FÜR EINEN BELEGUNGSPLAN MIT EINER MEHRZAHL VON SOLARELEMENTEN AUF EINER BELEGUNGSFLÄCHE**

(57)    Bei der Belegungsplanung einer Gebäudefassade muss entschieden werden, welche Solarelementmodelle für die Planung in Frage kommen. Mit dem erfindungsgemäßen Verfahren zur Auswahl zumindest eines Solarelementmodells für einen Belegungsplan mit einer Mehrzahl von Solarelementen auf einer Belegungsfläche wird basierend auf Eigenschaften der Belegungsfläche und der verfügbaren Solarelementmodelle eine Auswahl getroffen. Diese Auswahl kann neben den Abmessungen der Solarelementmodelle auch weitere relevante Eigenschaften berücksichtigen. Das Auswahlergebnis ermöglicht eine optimierte und einfach Belegungsplanung.

EP 4 660 865 A1

Fig. 1a

**Beschreibung**

Die Erfindung betrifft ein Verfahren zur Auswahl zumindest eines Solarelementmodells für einen Belegungsplan mit einer Mehrzahl von Solarelementen 3 auf einer Belegungsfläche 1 gemäß Anspruch 1.

Zur Energiegewinnung werden mehr und mehr Solarelemente in Gebäude, insbesondere auch Gebäudefassaden integriert. Die Verwendung von photovoltaischen Solarzellen zur Umwandlung elektromagnetischer Strahlung in elektrische Energie erfolgt üblicherweise mit einem Solarmodul, welches eine Mehrzahl von Solarzellen aufweist. Diese Solarzellen sind zur Bildung eines Solarmoduls typischerweise in Form von Solarzellenstrings verschaltet.

Beim Erstellen eines Belegungsplans für Solarelemente an einer Gebäudefassade ergibt sich für PlanerInnen zunächst die Frage nach der Auswahl geeigneter Modelle von Solarelementen. Bei der Auswahl eines solchen Solarelementmodells spielen mehrere Faktoren eine Rolle, wie beispielsweise Abmessungen, Effizienz, Kosten, Ästhetik, Verfügbarkeit. Darüber hinaus kann es noch viele weitere Aspekte geben, welche die Auswahl beeinflussen.

Auch bei der Anordnung solcher Solarelemente auf der Gebäudehülle ergeben sich verschiedene Herausforderungen, insbesondere an welchen Stellen auf der Gebäudehülle Solarelemente platziert werden. Hierbei spielen unterschiedlichste Aspekte, wie Wirtschaftlichkeit, Ästhetik und Umgebungsbedingungen sowie die verwendeten Solarelemente eine Rolle. Auch verschattete oder teilverschattete Gebäudehüllen oder eine spezielle Architektur können besondere Herausforderungen darstellen. Die Möglichkeiten zur Anordnung von Solarelementen sind durch die Maße der ausgewählten Solarelementmodelle begrenzt.

Aus dem Stand der Technik ist es bekannt, dass PlanerInnen das sogenannte Fugenbild erstellen. Gewünscht sind hierbei ein möglichst hoher Solarertrag, bei einer gleichzeitig ästhetisch ansprechenden Gebäudehülle und niedrigen Kosten. Naturgemäß gibt es sehr viele Möglichkeiten, wie eine Mehrzahl Solarelemente auf einer Gebäudehülle angeordnet werden kann, sodass es für PlanerInnen schwer bzw. kaum möglich ist, alle denkbaren Möglichkeiten zu prüfen. Dadurch besteht das Risiko, dass sich PlanerInnen für eine Belegung der Gebäudehülle entscheiden, die nicht optimal ist oder sich sogar gegen eine Belegung mit Solarelementen entschieden wird.

Der Erfindung liegt daher die Aufgabe zugrunde, geeignete Solarelemente aus einer Menge von Solarelementmodellen auszuwählen und somit eine einfache und optimierte Anordnung von Solarelementen auf einer Belegungsfläche zu ermöglichen.

Gelöst ist diese Aufgabe durch ein Verfahren zur Auswahl zumindest eines Solarelementmodells für einen Belegungsplan mit einer Mehrzahl von Solarelementen auf einer Belegungsfläche gemäß Anspruch 1. Vorteilhafte Ausgestaltungen des erfindungsgemäßen Verfahrens finden sich in den abhängigen Ansprüchen. Hiermit wird der Wortlaut sämtlicher Ansprüche explizit per Referenz in die Beschreibung einbezogen.

Das erfindungsgemäße Verfahren zur Auswahl zumindest eines Solarelementmodells für einen Belegungsplan mit einer Mehrzahl von Solarelementen auf einer Belegungsfläche, insbesondere auf einer Gebäudehülle, weist die folgenden Verfahrensschritte auf:

In einem Verfahrensschritt A erfolgt ein Bereitstellen der Belegungsfläche als Flächenmodell. Das Flächenmodell beinhaltet insbesondere Abmessungen der Belegungsfläche, Informationen zur Anordnung von Hindernissen und/oder Informationen zu Spezialflächen mit besonderen Anforderungen.

Üblicherweise besteht eine Gebäudehülle aus verschiedenen Flächen, die zueinander in einer festen Anordnung stehen. Auf diesen Flächen befinden sich Hindernisse wie Fenster oder Türen, die nicht für eine Belegung mit Solarelementen in Frage kommen. Auch kann es Flächen wie Balkonbrüstungen geben, die in einer anderen Ebene wie die umgebende Gebäudehüllfläche liegen. Das Flächenmodell enthält die erforderlichen Informationen zur Anordnung von Hindernissen und/oder Informationen zu Spezialflächen mit besonderen Anforderungen.

Für Solarelemente müssen üblicherweise Mindestabstände zu den Rändern der Gebäudehülle bzw. der Belegungsfläche, zu Hindernissen und zwischen den Solarelementen eingehalten werden. Auch diese Informationen fließen vorzugsweise in das Flächenmodell ein. Vorzugsweise ergibt sich im Ergebnis eine belegbare Nettofläche.

Verschiedene Solarelementmodelle können gleiche oder unterschiedliche Merkmale aufweisen. Das betrifft insbesondere deren Abmessungen, Effizienz, Kosten, Ästhetik und/oder Verfügbarkeit. In einem Verfahrensschritt B werden aus einer endlichen Menge von Solarelementmodellen Informationen zu deren Abmessungen bereitgestellt. Bei den Solarelementabmessungen handelt es sich zumindest um die äußeren Abmessungen in Form von Höhe und Breite jedes Solarelementmodells der endlichen Menge von Solarelementmodellen. Bei der Höhe und der Breite des Solarelementmodells handelt es sich um die Abmessungen parallel zur Fläche der Gebäudehülle. Vorzugsweise sind in der Höhe und Breite einzuhaltende Mindestabstände zwischen Solarelementen und/oder zu Rändern der Gebäudehülle bzw. der Belegungsfläche und/oder zu Hindernissen berücksichtigt. Insbesondere sind die einzuhaltenden Mindestabstände in alle erforderlichen Richtungen an den Rändern der Solarelemente, insbesondere bevorzugt individuell, berücksichtigt. Neben den Abmessungen werden vorzugsweise weitere Merkmale der Solarelemente bereitgestellt werden, wie insbesondere Daten, die wirtschaftliche, ökologische oder ästhetische Aspekte betreffen.

In einem Verfahrensschritt C werden Abstände im Flächenmodell bestimmt. Abstände befinden sich dabei zwischen benachbarten Hindernissen oder zwischen Begrenzungen der Belegungsfläche oder zwischen einem Hindernis und einer Begrenzung der Belegungsfläche. Abstände werden hierbei berücksichtigt, wenn sie sich auf ununterbrochenem Weg messen lassen, also ohne Unterbrechung durch ein weiteres Hindernis oder durch eine Begrenzung der Belegungsfläche.

In einem Verfahrensschritt D werden die in Verfahrensschritt C bestimmten Abstände derart gruppiert, dass sich eine Häufigkeitsverteilung hinsichtlich der Abstandswerte ergibt. Die Häufigkeitsverteilung ist dabei nicht beschränkt auf Darstellungsformen, die nur Wertepaare aus Abständen und deren Häufigkeit enthalten, wie bevorzugt zweidimensionale Histogramme. Vorzugsweise sind zusätzliche Informationen bezüglich der Position der Abstände im Flächenmodell vorhanden, weshalb auch komplexere Datenstrukturen im Sinn des erfindungsgemäßen Verfahrens sind. Solche komplexeren Datenstrukturen sind bevorzugt Tabellen. Insbesondere bevorzugt wird die Häufigkeitsverteilung in Form einer Tabelle mit zumindest den folgenden Daten erstellt: Anzahl der Hindernisse mit gleichen Koordinaten ihrer linken unteren Ecke und ihrer rechten unteren Ecke, wodurch Hindernisse mit gleichen Maßen in vertikaler Richtung zu einer Hindernisgruppe gruppiert werden, sowie den Abstand zur benachbarten linken und zur benachbarten rechten Hindernisgruppe.

In einem Verfahrensschritt E wird für mehrere Solarelementmodelle jeweils ein Eignungsmaß $EM_{SEi}$ errechnet. Das Eignungsmaß hängt von den Abmessungen eines Solarelementmodells ab und wird für mehrere der in Verfahrensschritt C berechneten Abstände bestimmt. Der Wert des Eignungsmaßes $EM_{SEi}$ quantifiziert die Eignung eines Solarelementmodells, einen Abstand im Flächenmodell mit Solarelementen des betrachteten Solarelementmodells zu belegen. In die Berechnung des Eignungsmaßes fließen neben den Solarelementabmessungen vorzugsweise weitere Daten des Solarelementmodells ein, die in Verfahrensschritt B bereitgestellt werden.

In einem Verfahrensschritt F wird abhängig vom Eignungsmaß $EM_{SEi}$ und bevorzugt der in Verfahrensschritt D bestimmten Häufigkeitsverteilung zumindest ein Solarelementmodell ausgewählt. Vorzugsweise wird für jeden Abstand dasjenige Solarelementmodell ausgewählt, das für den jeweiligen Abstand das größte Eignungsmaß $EM_{SEi}$ besitzt. Dabei liegt es im Rahmen der Erfindung, dass PlanerInnen wichtige, insbesondere häufig auftretende Abstände auf der Gebäudehülle auswählen und dafür Solarelementmodelle bestimmen lassen. Alternativ oder zusätzlich erfolgt die Auswahl automatisiert anhand der Häufigkeitsverteilung aus Verfahrensschritt D.

Durch die Anwendung des Verfahrens in der Planungsphase werden nicht bereits tatsächliche Solarelemente angeordnet. Die tatsächliche bauliche Umsetzung ist nicht Teil der Auswahl oder des Belegungsplans. Im Rahmen dieser Beschreibung ist mit den Formulierungen "Anordnen" oder "Platzieren" eines Solarelements gemeint, ein Solarelements an einer Stelle im Flächenmodell gedacht zu positionieren. Dabei gilt ein Solarelement dann als "platzierbar", wenn es möglich ist, es innerhalb der Begrenzung des Flächenmodells anzuordnen und es dabei kein Hindernis, keine Begrenzung des Flächenmodells und kein weiteres Solarelement überdeckt.

In einer bevorzugten Ausführungsform des Verfahrens werden in einem ergänzenden Verfahrensschritt G Solarelemente eines oder mehrerer in Verfahrensschritt F ausgewählten Solarelementmodelle im Flächenmodell angeordnet. Diese Anordnung basiert auf dem Eignungsmaß $EM_{SEi}$ der ausgewählten Solarelementmodelle. Hierdurch ergibt sich der Vorteil, dass die Gebäudehülle mit Solarelementen mit optimalen Außenabmessungen belegt wird und möglichst wenig Lücken verbleiben.

Wird in einem der in Verfahrensschritt C bestimmten Abstände die maximale Anzahl $n_{max}$ von Solarelementen eines Solarelementmodells aneinandergereiht platziert, dann ergibt sich im Allgemeinen ein Restabstand L. In einer weiteren Ausführungsform des Verfahrens hängt das Eignungsmaß $EM_{SEi}$ zusätzlich von diesem Restabstand - bevorzugt antiproportional - ab, der sich für jede Kombination aus Solarelementmodell und Abstand ergibt. Um die verfügbare Fläche effizient auszunutzen, ist es vorteilhaft, wenn der Restabstand minimiert wird.

Dazu alternativ oder ergänzend hängt das Eignungsmaß $EM_{SEi}$ vorzugsweise von der maximalen Anzahl $n_{max}$ der so platzierten Solarelemente und/oder der Gesamtfläche S der Solarelemente ab. Eine Berücksichtigung von $n_{max}$ ist dann vorteilhaft, wenn es von Interesse ist, dass möglichst wenige Solarelemente platziert werden sollen, beispielsweise wenn eine möglichst einfache Verschaltung der Solarelemente angestrebt wird. Eine große Gesamtfläche S der Solarelemente ermöglicht eine effiziente Nutzung der zur Verfügung stehenden Gebäudefläche als solaraktive Fläche. Von diesen Alternativen oder Ergänzungen sind insbesondere auch zueinander gewichtete Kombinationen dieser Größen umfasst, wodurch eine individuelle Abwägung der durch die einzelnen Größen angestrebten Ziele erreicht wird. Vorzugsweise hängt das Eignungsmaß $EM_{SEi}$ antiproportional von der maximalen Anzahl $n_{max}$ der platzierten Solarelemente ab.

$$EM_{SEi} = a_1 \frac{1}{L} + a_2 \frac{1}{n_{max}} + a_3 S$$

Bevorzugt berechnet sich das Eignungsmaß $EM_{SEi}$ wie folgt: , wobei $a_1$, $a_2$, $a_3$ reelle Gewichtungsfaktoren der Einzelterme sind. L ist der oben beschriebene Restabstand L, $n_{max}$ die maximale Anzahl platzierbarer Solarelemente und S die Gesamtfläche der Solarelemente. Die Formeln stellen durch die Summation der Einzelterme eine einfache Möglichkeit zur Berechnung des Eignungsmaßes $EM_{SEi}$ dar.

In einer alternativen Ausführungsform der Erfindung berechnet sich das Eignungsmaß $EM_{SEi}$ wie folgt:

$$EM_{SEi} = \frac{1}{a_1 L + a_2 n_{max} + a_3 \frac{1}{S}}$$

, wobei $a_1$, $a_2$, $a_3$ reelle Gewichtungsfaktoren der Einzelterme sind. L ist der oben

beschriebene Restabstand L, $n_{max}$ die maximale Anzahl platzierbarer Solarelemente und S die Gesamtfläche der Solarelemente. Die Formeln stellen durch die Summation der Einzelterme eine einfache Möglichkeit zur Berechnung des Eignungsmaßes $EM_{SEi}$ dar.

In einer weiteren bevorzugten Ausführungsform des erfindungsgemäßen Verfahrens findet ein dem Verfahrensschritt E vorgeschalteter Verfahrensschritt E0 statt. In diesem Verfahrensschritt E0 werden die Solarelementmodelle derart gruppiert, dass eine Untergruppe der in Verfahrensschritt B eingeführten endlichen Menge gebildet wird. Die Untergruppe stellt eine unechte Teilmenge der endlichen Menge von Solarelementmodellen dar. Vorzugsweise wird die Gruppierung anhand wirtschaftlicher, ökologischer und/oder ästhetischer Gesichtspunkte durchgeführt. Insbesondere bevorzugt wird für jedes Solarelement der in Verfahrensschritt E0 gebildeten Untergruppe der Verfahrensschritt E durchgeführt. Durch diese Ausführungsform ergibt sich der Vorteil, dass Kriterien wie eine bestimmte Optik, maximale Kosten, Effizienz für die Solarelemente vorgegeben werden können. Darüber hinaus wird das erfindungsgemäße Verfahren besonders recheneffizient ausgeführt, indem nicht jede der möglichen Kombinationen geprüft werden muss.

Vorzugsweise wird in Verfahrensschritt E des erfindungsgemäßen Verfahrens das Eignungsmaß $EM_{SEi}$ für jedes der in der Untermenge enthaltenen Solarelementmodelle für mehrere der in Verfahrensschritt C bestimmten Abstände errechnet. Auch diese Ausführungsform ermöglicht eine effiziente Ausführung des Verfahrens.

In einer bevorzugten Ausführungsform des erfindungsgemäßen Verfahrens wird ein zusätzlicher Verfahrensschritt F0 dem Verfahrensschritt F vorgeschaltet, in dem für jedes Solarelementmodell der Untergruppe ein gewichteter Mittelwert der zugehörigen Eignungsmaße $EM_{SEi}$ berechnet wird. Die Gewichtung erfolgt anhand der in Verfahrensschritt D bestimmten Häufigkeitsverteilung der Abstände. Abstände werden umso höher gewichtet, je häufiger sie vorkommen.

In einer weiteren bevorzugten Ausführungsform des erfindungsgemäßen Verfahrens wird zumindest dasjenige Solarelementmodell als ausgewähltes Solarelementmodell ausgewählt, für das in Verfahrensschritt F0 der höchste gewichtete Mittelwert der Eignungsmaße $EM_{SEi}$ berechnet wurde. Bevorzugt wird die maximale Anzahl platzierbarer Solarelemente des ausgewählten Solarelementmodells als Startreihe zwischen zwei horizontal benachbarten Hindernissen angeordnet und als platzierbare Solarelemente in den zu erstellenden Belegungsplans übertragen. In einem nächsten Schritt werden bevorzugt über und/oder unter der Startreihe weitere Reihen von platzierbaren Solarelemente des ausgewählten Solarelementmodells angeordnet bis zu einem vertikal nächstliegenden Hindernis.

Alternativ wird zunächst die maximale Anzahl platzierbarer Solarelemente des ausgewählten Solarelementmodells als Startreihe zwischen zwei vertikal benachbarten Hindernissen angeordnet und als platzierbare Solarelemente in den zu erstellenden Belegungsplans übertragen. In einem nächsten Schritt werden bevorzugt in horizontaler Richtung rechts oder links der Startreihe weitere Reihen von platzierbaren Solarelemente des ausgewählten Solarelementmodells angeordnet bis zu einem horizontal nächstliegenden Hindernis. Im Verfahrensschritt G, in dem ein Belegungsplan erstellt wird, wird dadurch ein Abstand mit der maximalen Anzahl von Solarelementen aufgefüllt. Die Reihe von Solarelementen, die sich durch das Auffüllen ergibt, ist die Startreihe. Ausgehend von jedem Solarelement der Startreihe werden dann orthogonal weitere Solarelemente platziert, bis ein Hindernis oder eine Begrenzung der Belegungsfläche erreicht ist. Die Startreihe erstreckt sich in horizontaler oder in vertikaler Richtung bezüglich des Flächenmodells. Durch diese Ausführungsformen ergibt sich der Vorteil, dass ein streifenartiges Muster entsteht, das entsprechende ästhetische Anforderungen erfüllt und sich vorteilhaft in eine regelmäßige Architektur mit vielen Rechtecken einfügt.

In einer weiteren bevorzugten Ausführungsform des erfindungsgemäßen Verfahrens wird beim Erstellen des Belegungsplans in Verfahrensschritt G für mehrere der in Verfahrensschritt C bestimmten Abstände dasjenige Solarelementmodell ausgewählt, das für den jeweiligen Abstand das größte Eignungsmaß $EM_{SEi}$ besitzt. Im Allgemeinen werden in dieser Ausführung mehrere verschiedene Solarelementmodelle zum Einsatz kommen, die optimal die verfügbare Belegungsfläche ausnutzen können.

Bevorzugt berücksichtigt das erfindungsgemäße Verfahren in Verfahrensschritt E eine vorgegebene, maximale Anzahl an Abständen, für die das Eignungsmaß $EM_{SEi}$ berechnet wird. Typischerweise sind Gebäudehüllen derart beschaffen sein, dass einige wenige Abstände häufig auftreten und gleichzeitig viele Abstände nur einmal auftreten, wobei es vorteilhaft sein könnte, das Eignungsmaß $EM_{SEi}$ nur für die häufig auftretenden Abstände zu berechnen. Dies ermöglicht eine effiziente Berechnung, indem selten auftretende Abstände ignoriert werden und dadurch die Komplexität der Berechnung reduziert wird.

In einer weiteren Ausführung des erfindungsgemäßen Verfahrens ist die maximale Anzahl an Solarelementmodellen vorgebbar, die bei der Erstellung des Belegungsplans in Verfahrensschritt G genutzt wird. Es könnte vorteilhaft sein, absteigend sortiert nach dem gewichteten Mittelwert der Eignungsmaße $EM_{SEi}$ nur eine gewisse Anzahl an Solarelementmodellen zuzulassen, um Rechenleistung oder Zeit zu sparen.

Vorzugsweise berechnet man aus den Eignungsmaßen $EM_{SEi}$ für einen oder mehrere Abstände i das Eignungsmaß $EM_{SE}$. Vorzugsweise gewichtet man dabei die Eignungsmaße $EM_{SEi}$ mit der Häufigkeit der Abstände H(i):

$$EM_{SE} = \sum_{i=1}^{i_{max}} H(i)\, EM_{SEi}$$

Um Rechenzeit zu sparen, kann die maximale Anzahl der berücksichtigten Abstände $i_{max}$ so gewählt werden, dass nur die wichtigsten Abstände berücksichtigt werden. Bevorzugt wird im ersten Schritt das "erste" Solarelementmodell ausgewählt, das von allen untersuchten Solarelementmodellen das höchste Eignungsmaß $EM_{SE}$ aufweist. Das bedeutet, dass es die zur Verfügung stehende Fläche besser ausnutzt als die anderen Solarelemente.

Im nächsten Schritt kann man prüfen, welches Solarelementmodell das erste Solarelement am besten ergänzt, weil es für ein oder mehrere Abstände die zur Verfügung stehende Fläche besser nutzt. Für einen solchen Belegungsplan aus zwei Solarelementmodellen kann ebenfalls das Eignungsmaß $EM_{SE}$ berechnet werden. Das Eignungsmaß des zweiten Schritts $EM_{SE,Schritt2}$ muss größer sein als das Eignungsmaß des ersten Schritts $EM_{SE,Schritt1}$, wenn das zweite Solarelementmodell einen Vorteil bringt.

In einer bevorzugten Ausführung des erfindungsgemäßen Verfahrens werden zwei Differenzen berechnet: Die Differenz $\Delta_{EM,inkrementell}$ zwischen dem Eignungsmaß des in Schritt j bestimmten j-ten Solarelementmodells $EM_{SE,Schritt\,j}$ und dem Eignungsmaß des vorherigen Schritts (j-1) $EM_{SE,Schritt\,(j-1)}$:

$$\Delta_{EM,inkrementell} = EM_{SE,Schritt\,j} - EM_{SE,Schritt\,(j-1)}$$

Für die Differenz $\Delta_{EM,inkrementell}$ kann ein Mindestwert $\Delta_{EM,inkrementell,min}$ definiert werden. Der Mindestwert $\Delta_{EM,inkrementell,min}$ bedeutet, dass man auf weitere Schritte und damit Solarelementmodelle verzichtet, wenn die Differenz $\Delta_{EM,inkrementell}$ und damit der Vorteil des zusätzlichen Solarelementmodells j zu klein ist.

Die Differenz $\Delta_{EM,gesamt}$ zwischen dem Eignungsmaß des in Schritt j bestimmten j-ten Solarelementmodells $EM_{SE,Schritt\,j}$ und dem Eignungsmaß des ersten Schritts $EM_{SE,Schritt1}$:

$$\Delta_{EM,gesamt} = EM_{SE,Schritt\,j} - EM_{SE,Schritt1}$$

Für die Differenz $\Delta_{EM,gesamt}$ kann ein Maximalwert $\Delta_{EM,gesamt,max}$ definiert werden. Der Maximalwert $\Delta_{EM,gesamt,max}$ ist ein Maß dafür, wie wichtig PlanerInnen Verbesserungen sind im Vergleich zum Mehraufwand von zusätzlichen Solarelementen.

Wenn der Mindestwert $\Delta_{EM,inkrementell,min}$ gegen null geht oder der Maximalwert $\Delta_{EM,ge-samt,max}$ gegen unendlich geht, dann wird die zur Verfügung stehende Fläche optimal ausgenutzt mit so vielen Solarelementmodellen, wie dafür nötig sind. Wenn ein großer Mindestwert $\Delta_{EM,inkrementell,min}$ ausgewählt wird oder ein kleiner Maximalwert $\Delta_{EM,ge-samt,max}$, dann werden nur wenige Solarelemente ausgewählt, die die zur Verfügung stehende Fläche so gut ausnutzen, wie es dieser Anzahl von Solarelementen möglich ist.

Eine weitere Ausführung des erfindungsgemäßen Verfahrens sieht vor, dass der Verfahrensschritt E so häufig wiederholt wird, bis zumindest eine Abbruchbedingung erfüllt ist. Abbruchbedingungen stellen insbesondere die folgenden Fälle dar: die maximale Anzahl zu berücksichtigender Solarelementmodelle ist erreicht, oder die Anzahl zu berücksichtigender Abstände $n_{Abstände}$ je Solarelementmodell ist erreicht, oder eine Differenz $\Delta_{EM,inkrementell}$ zwischen dem Eignungsmaß des in Schritt j bestimmten j-ten Solarelementmodells $EM_{SE,Schritt\,j}$ und dem Eignungsmaß der letzten Wiederholung des Verfahrensschrittes E $EM_{SE,Schritt\,(j-1)}$ ist kleiner als eine vorgebbare Mindestdifferenz $\Delta_{EM,inkrementell,min}$. oder eine Differenz $\Delta_{EM,gesamt}$ zwischen dem Eignungsmaß des in Schritt j bestimmten j-ten Solarelementmodells $EM_{SE,Schritt\,j}$ und dem Eignungsmaß $EM_{SE,Schritt1}$ der ersten Wiederholung des Verfahrensschrittes E ist größer als eine vorgebbare Maximaldifferenz $\Delta_{EM,gesamt,max}$. Vorzugsweise liegt die maximale Anzahl zu berücksichtigender Solarelementmodelle im Bereich von 2 bis 5, bevorzugt bei 3. Vorzugsweise liegt das Verhältnis $\Delta_{EM,inkrementell,min}/EM_{SE,Schritt1}$ der vorgebbare Mindestdifferenz $\Delta_{EM,inkrementell,min}$ und des Eignungsmaßes der ersten Wiederholung $EM_{SE,Schritt1}$ im Bereich von 1% bis 20%, bevorzugt bei 10%. Vorzugsweise liegt das Verhältnis $\Delta_{EM,ge-samt,max}/EM_{SE,Schritt1\,der}$ der vorgebbaren Maximaldifferenz $\Delta_{EM,gesamt,max}$ und des Eignungsmaßes der ersten Wiederholung im Bereich von 10% bis 100%, bevorzugt bei 50%.

Dies bedeutet jedoch nicht, dass andere denkbare Abbruchbedingungen davon nicht umfasst sind, beispielsweise könnten die Eignungsmaße $EM_{SEi}$ aller Abstände für alle Solarelementmodelle berechnet worden sein. Durch den Abbruch des Verfahrens bei bestimmten Bedingungen werden überflüssige Berechnungen vermieden, wodurch das Verfahren effizienter durchgeführt wird.

In einer bevorzugten Ausführungsform des erfindungsgemäßen Verfahrens werden folgende Schritte durchgeführt:

In Verfahrensschritt A erstellt die PlanerIn ein Flächenmodell basierend auf Abmessungen der Gebäudehülle. Alternativ wird das Flächenmodell aus einer Datenbank abgerufen werden, in die es zu einem früheren Zeitpunkt eingetragen wurde.

Für PlanerInnen stellt sich die Frage, mit welchen Solarelementmodellen die Belegungsfläche besetzt werden soll. Es könnte sich ein einziges Solarelementmodell oder eine Kombination unterschiedlicher Modelle mit unterschiedlichen Abmessungen als optimal erweisen.

Die Informationen zu den Abmessungen verschiedener Solarelementmodelle liegen vorzugsweise als Datenbankeinträgen vor. Die Solarelementmodelle unterscheiden sich üblicherweise nicht nur hinsichtlich ihrer Abmessungen, sie können sich auch im Preis und in Effizienzen sowie in weiteren relevanten Eigenschaften unterscheiden.

Die Solarelementmodelle sollen derart ausgewählt werden, dass sie gut zur Beschaffenheit und Form der Belegungsfläche passen. Dafür werden in Verfahrensschritt C die Abstände zwischen Hindernissen in horizontaler und in vertikaler Richtung bestimmt. Außerdem werden die Abstände zu Begrenzungen der Belegungsfläche ermittelt.

Dabei wird ersichtlich, dass sich einige Abstände häufig wiederholen und andere nur selten auftreten. In Verfahrensschritt D wird eine Häufungsverteilung dieser Abstandswerte erstellt. Die Hindernisse werden vorzugsweise nach den Koordinaten ihrer linken und rechten unteren Ecke gruppiert. Diese bevorzugte Ausführungsform ist besonders geeignet, wenn horizontale Abstände zwischen Hindernissen mit Solarelementen belegt werden sollen.

Alternativ werden die Hindernisse vorzugsweise nach den Koordinaten ihrer linken unteren und linken oberen oder ihrer rechten unteren und rechten oberen Ecke gruppiert. Diese bevorzugte Ausführungsform ist besonders geeignet, wenn vertikale Abstände zwischen Hindernissen mit Solarelementen belegt werden sollen.

Nicht-rechteckige Hindernisse werden vorzugsweise anhand des kleinstmöglichen Rechtsecks, welches das Hindernis vollständig einschließt, entsprechend eingruppiert.

Durch die oben beschriebenen Varianten entstehen mehrere Hindernisgruppen. Für jede der Hindernisgruppen wird der Abstand zu den nächstgelegenen Hindernisgruppen und/oder zur Begrenzung des Flächenmodells bestimmt und zusammen mit der Anzahl der Hindernisse in jeder Gruppe in eine Tabelle eingetragen. Dabei werden Wertepaare aus der Anzahl der Hindernisse und dem Abstand zur linken bzw. zur rechten Hindernisgruppe und/oder zur Begrenzung des Flächenmodells gebildet. Einträge in der Tabelle, die gleiche Abstandwerte aufweisen, werden ersetzt durch Einträge, deren Anzahlwert der Summe der Hindernisse entspricht. Die Tabelle wird absteigend nach der Anzahl der Hindernisse in der Gruppe sortiert, sodass Abstände, die sich im Flächenmodell häufig wiederholen, oben in der Tabelle stehen.

Um zu berücksichtigen, dass einige der Solarelementmodelle zu teuer sind und/oder andere aufgrund ihrer ökologischen Bilanz ausscheiden und/oder andere Kriterien nicht erfüllen, wird daher im Verfahrensschritt E0 eine Untergruppe derjenigen Solarelementmodelle definiert, die weiterhin in Frage kommen.

In Verfahrensschritt E wird für jedes Solarelementmodell der zuvor bestimmten Untergruppe das Eignungsmaß $EM_{SEi}$ berechnet. Das Eignungsmaß $EM_{SEi}$ hängt von den Solarelementabmessungen und einem Abstand ab. Vorzugsweise wird eine vorgebbare Anzahl $n_{maxAbstände}$ an Abständen berücksichtigt. Dazu wird die Häufigkeitsverteilung der Abstände aus Verfahrensschritt D herangezogen und um die $n_{maxAbstände}$ am häufigsten auftretenden Abstände zu finden. Indem die Tabelle absteigend nach der Hindernisanzahl sortiert wurde, sind das hier die $n_{maxAbstände}$ obersten Einträge in der Tabelle.

Das Eignungsmaß $EM_{SEi}$ errechnet sich vorzugsweise aus $$EM_{SEi} = \frac{a_1}{L} + \frac{a_2}{n_{max}} + a_3 S$$ . Dabei ist $L$ die Größe des Restabstands, der verbleibt, wenn im betrachteten Abstand die größtmögliche Anzahl von Solarelementen, $n_{max}$, angeordnet wird. $S$ bezeichnet die Gesamtfläche der angeordneten Solarelemente. $a_1$, $a_2$, $a_3$ sind Gewichtungsfaktoren für die einzelnen Summanden. Die Werte der Gewichtungsfaktoren unterscheiden sich zueinander um vorzugsweise bis zu drei Größenordnungen.

Für $a_1 > a_2 = a_3$ wird beim Eignungsmaß $EM_{SEi}$ besonders derjenige Term gewichtet, der groß wird, wenn der Restabstand klein ist. In einer bevorzugten Ausführungsform werden mit den Gewichtungsfaktoren $a_1 = 1000$, $a_2 = 1$, $a_3 = 1$ bevorzugt Solarelementmodelle gewählt, durch die der Restabstand minimiert wird. Dies ist insbesondere ökologisch und ästhetisch vorteilhaft.

In einer bevorzugten Ausführungsform werden mit den Gewichtungsfaktoren $a_1 = 1$, $a_2 = 1000$, $a_3 = 1$ bevorzugt Solarelementmodelle gewählt, von denen nur wenige nebeneinander benötigt werden, um die Abstände zu füllen. Das führt zu einem großflächigeren Erscheinungsbild und kann wirtschaftlich vorteilhaft sein.

In einer bevorzugten Ausführungsform werden mit den Gewichtungsfaktoren $a_1 = 1$, $a_2 = 1$, $a_3 = 1000$ bevorzugt großflächige Solarelementmodelle gewählt. Auf diese Weise müssen weniger Solarelemente miteinander verbunden werden, was wirtschaftlich vorteilhaft sein kann.

In einer bevorzugten Ausführungsform werden mit den Gewichtungsfaktoren $a_1 = 1$, $a_2 = 1000$, $a_3 = 1000$ werden bevorzugt wenige großflächige Solarelementmodelle gewählt, die die Abstände zwischen den Hindernissen allerdings weniger gut ausnutzen als mit den Gewichtungsfaktoren $a_1 = 1000$, $a_2 = 1$, $a_3 = 1$. Mischformen sowie weniger strake Ausprägungen der Gewichtungsfaktoren führen zu Ergebnissen mit abweichender Schwerpunktsetzung und können abhängig von den Gegebenheiten der Gebäudehülle vorteilhaft sein.

Der Verfahrensschritt E wird wiederholt, bis ein Abbruchkriterium erfüllt ist.

In Verfahrensschritt F werden diejenigen Solarelementmodelle ausgewählt, die für jeden der berücksichtigten Abstände das größte Eignungsmaß $EM_{SEi}$ besitzen.

Mit diesen Solarelementmodellen wird in einem Verfahrensschritt G ein Belegungsplan erstellt, indem mehrere Solarelemente der ausgewählten Solarelementmodelle in den Abständen angeordnet werden. Vorzugsweise wird zuerst der am häufigsten vorkommende Abstand in der Belegungsfläche aufgefüllt mit Solarelementen des entsprechenden Solarelementmodells. Dadurch wird für diesen Abstand die Startreihe gebildet. Ausgehend von jedem Solarelement dieser Startreihe werden dazu in orthogonaler Richtung weitere Solarelemente platziert, bis entweder ein weiteres Hindernis oder eine Begrenzung der Belegungsfläche erreicht würde. Mit dem nächsthäufigen zu berücksichtigenden Abstand wird analog verfahren. Dadurch entsteht ein streifenartiges Muster. Mit dem beschriebenen bevorzugten erfindungsgemäßen Verfahren ergibt sich der Vorteil, dass die Auswahl des passenden Solarelementmodells für PlanerInnen automatisiert und stark vereinfacht wird. Dabei können individuell nicht nur die geometrischen Abmessungen, sondern auch Kriterien des Solarelementmodells berücksichtigt werden.

In einer bevorzugten Ausführungsform des erfindungsgemäßen Verfahrens wird zunächst das am besten geeignete Solarelementmodell bestimmt und danach das Solarelementmodell bestimmt, dass dieses für die Bedingungen im Flächenmodell gemäß dem gewichteten Eignungsmaßes am besten ergänzt, indem es das erste Solarelementmodell auf den dafür geeigneten Flächen ersetzt. Vorzugsweise werden ggf. noch weitere Solarelementmodelle bestimmt, die die vorhergehenden am besten ergänzen.

Dazu wird vorzugsweise für jeden Abstand i zwischen zwei Hindernissen eine Tabelle erstellt. Für jedes Solarelement j, das die Mindesteigung erfüllt, wird das Eignungsmaß berechnet. Davon ausgehend wird die Differenz zwischen dem Eignungsmaß des Solarelements j und dem Eignungsmaß des ersten, bereits ausgewählten Solarelementmodell berechnet. Für alle Abstände, bei denen diese Differenz positiv ist, ist dieses Solarelementmodell vorteilhafter als das erste, bereits ausgewählte Solarelementmodell.

Vorzugsweise wird aus allen positiven Differenzen des Eignungsmaßes der Mittelwert dieser Differenz gewichtet nach der Anzahl der Abstände berechnet. Als zweites ausgewähltes Solarelementmodell wird das das Solarelementmodell mit der höchsten Differenz ausgewählt.

Der Mittelwert kann dabei auf zwei verschiedene Weisen gebildet werden. Im ersten Fall wird die die absolute Differenz $\Delta_{EM,absolut}$ bezogen auf alle Abstände berechnet:

$$
\begin{aligned}
\Delta_{EM,absolut} \\
= \frac{1}{n_{(EM_{SEi,Schritt2}-EM_{SEi,Schritt1})>0}} \sum_{\forall i \,|\, (EM_{SEi,Schritt2}-EM_{SEi,Schritt1})>0} H(i)EM_{SEi,Schritt2} \\
- \frac{1}{n_i} \sum_{\forall i} H(i)EM_{SEi,Schritt1}
\end{aligned}
$$

Dabei ist $n_{(EM_{SEi,Schritt2}-EM_{SEi,Schritt1})>0}$ die Anzahl der Abstände, bei denen die Differenz ($EM_{SEi,Schritt2}$ - $EM_{SEi,Schritt1}$) positiv ist, und $n_i$ die Anzahl aller Abstände i. Dieses Berechnung bevorzugt Solarelementmodelle, die gegenüber dem ersten Solarelementmodell für viele Abstände einen Vorteil bringen, auch wenn dieser Vorteil klein ist.

Im zweiten Fall wird die relative Differenz $\Delta_{EM,relativ}$ bezogen auf alle Abstände berechnet, bei denen das zweite Solarelementmodell vorteilhaft ist:

$$
\begin{aligned}
\Delta_{EM,relativ} \\
= \frac{1}{n_{(EM_{SEi,Schritt2}-EM_{SEi,Schritt1})>0}} \sum_{\forall i \,|\, (EM_{SEi,Schritt2}-EM_{SEi,Schritt1})>0} H(i)EM_{SEi,Schritt2} \\
- \frac{1}{n_{(EM_{SEi,Schritt2}-EM_{SEi,Schritt1})>0}} \sum_{\forall i \,|\, (EM_{SEi,Schritt2}-EM_{SEi,Schritt1})>0} H(i)EM_{SEi,Schritt1})
\end{aligned}
$$

Diese Berechnung bevorzugt Solarelementmodelle, die gegenüber dem ersten Solarelementmodell einen großen Vorteil bei einer kleinen Zahl von Abständen bringen. In der obigen Berechnung der Mittelwert stehen Schritt 1 und 2 für beliebige aufeinanderfolgende Berechnungen für mehrere Abstände zwischen Hindernissen.

Diese Schritte werden für jeden Abstand i zwischen zwei Hindernissen wiederholt, und die Differenz zwischen dem Eignungsmaß des Solarelements j und dem Eignungsmaß des ersten Solarelementmodells sowie die Differenzen zu den weiteren Solarelementmodellen werden verglichen, bis ein Abbruchkriterium erreicht ist.

In einer bevorzugten Ausführungsform des erfindungsgemäßen Verfahrens wird das Verfahren als computerimplementiertes Verfahren zum Erstellen eines Belegungsplans nach einem der vorangegangenen Ansprüche realisiert. Weiter beansprucht ist ein Computerprogramm mit Anweisungen, die, wenn das Programm von einem Computer ausgeführt wird, den Computer veranlassen, das erfindungsgemäße Verfahren oder eine bevorzugte Ausführungsform des erfindungsgemäßen Verfahrens auszuführen. Die Umsetzung des erfindungsgemäßen Verfahrens als Computerprogramm ist vorteilhaft, um automatisiert das erfindungsgemäße Verfahren und/oder eine bevorzugte Ausführungsform durchführen zulassen. Hierdurch ergibt sich der Vorteil, dass PlanerInnen automatisiert und schnell eine optimierte Auswahl von Solarelementmodellen erhalten und gegebenenfalls damit einen Belegungsplan erstellen können.

Im Folgenden werden einige Ausführungsbeispiele des erfindungsgemäßen Verfahrens anhand von Figuren erläutert. Dabei zeigt:

Figur 1    eine schematische Darstellung einer Belegungsfläche sowie eine Menge an Solarelementen;
Figur 2    verschiedene Solarelementmodelle mit unterschiedlichen Abmessungen in einem Abstand angeordnet;
Figur 3    einen Belegungsplan als Ergebnis der Durchführung eines erfindungsgemäßen Verfahrens einschließlich Verfahrensschritt G.

Eine PlanerIn steht vor der Aufgabe, für ein Gebäude eine Auswahl an Solarelementmodellen 3 zu treffen, mittels derer die Gebäudefassade bestück werden soll.

Im ersten Schritt des erfindungsgemäßen Verfahrens, Verfahrensschritt A, erstellt die PlanerIn ein Modell basierend auf Abmessungen, die eine Gebäudeseite betreffen.

Dazu bedient die PlanerIn sich einer geeigneten Schnittstelle und macht das Flächenmodell zugänglich, sodass es zu relevanten Zeitpunkten im Verfahren abgerufen werden kann. Alternativ könnte das Flächenmodell aus einer Datenbank abgerufen werden, in die es zu einem früheren Zeitpunkt eingetragen wurde.

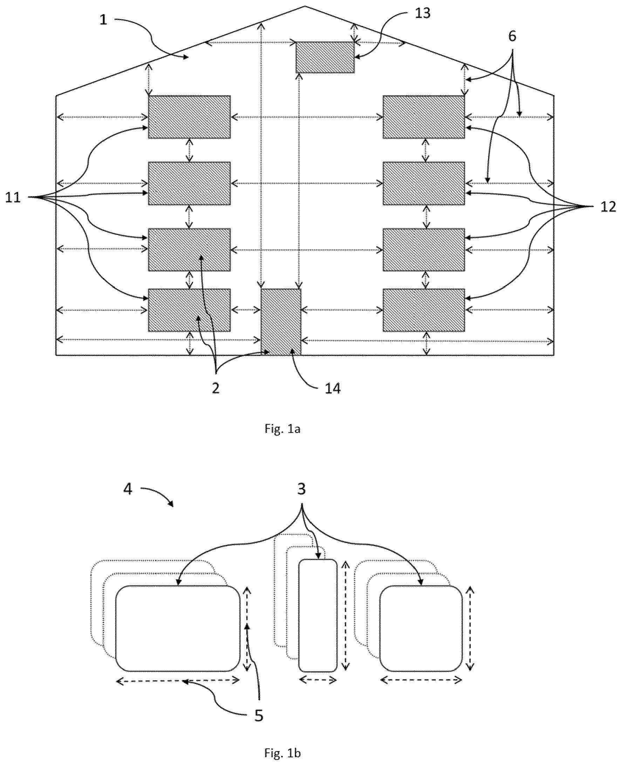

Ein Flächenmodell ist in Figur 1a gezeigt. Hierbei handelt es sich um eine Seite einer mit Solarelementen 3 zu bestückenden Gebäudefassade, die als Belegungsfläche 1 dient. Auf der Gebäudefassade sind mehrere Flächen gekennzeichnet, die nicht mit Solarelementen bestückt werden können. Bei diesen Flächen handelt es sich um Fenster und eine Tür. Sie stellen Hindernisse 2 bei der Belegung dar. Diese Flächen und deren Position werden in das Flächenmodell übertragen.

Für PlanerInnen stellt sich die Frage, mit welchen Solarelementmodellen 3 die Belegungsfläche 1 besetzt werden soll. Es könnte sich ein einziges Solarelementmodell 3 oder eine Kombination unterschiedlicher Typen als optimal erweisen.

In Figur 1b ist eine endliche Menge 4 von Solarelementmodellen 3 dargestellt. Die Menge 4 könnte aus Datenbankeinträgen ausgewählt werden. Vorliegend sind drei Solarelementmodelle 3 mit unterschiedlichen Solarelementabmessungen 5 gezeigt, welche die PlanerIn in Verfahrensschritt B in Betracht zieht. Die Solarelementmodelle unterscheiden sich aber nicht nur hinsichtlich ihrer Abmessungen, sie können sich auch im Preis und in Effizienzen sowie in weiteren relevanten Eigenschaften unterscheiden.

Die Solarelementmodelle 3 sollen derart ausgewählt werden, dass sie gut zur Beschaffenheit und Form der Belegungsfläche 1 passen. Dafür werden in Verfahrensschritt C die Abstände 6 zwischen Hindernissen in horizontaler und in vertikaler Richtung bestimmt. Außerdem werden die Abstände 6 zu Begrenzungen der Belegungsfläche 1 ermittelt. Dies ist in Figur 1a gezeigt.

Dabei wird ersichtlich, dass sich einige Abstände 6 häufig wiederholen und andere nur selten auftreten. In Verfahrensschritt D wird eine Häufungsverteilung dieser Abstandswerte erstellt. Die Hindernisse werden vorliegend nach den Koordinaten ihrer linken und rechten unteren Ecke gruppiert. Dadurch entstehen vier Hindernisgruppen: eine linke Spalte mit vier Fenstern 11, eine rechte Spalte mit vier Fenstern 12, ein Fenster am Dachgiebel 13 und eine Tür 14. Für jede der Hindernisgruppen wird der Abstand zu den nächstgelegenen Hindernisgruppen und zur Begrenzung des Flächenmodells bestimmt und zusammen mit der Anzahl der Hindernisse in jeder Gruppe in eine Tabelle eingetragen. Dabei werden Wertepaare aus der Anzahl der Hindernisse und dem Abstand zur linken bzw. zur rechten Hindernisgruppe gebildet. Einträge in der Tabelle, die gleiche Abstandwerte aufweisen, werden ersetzt durch Einträge, deren Anzahlwert der Summe der Hindernisse entspricht. Die Tabelle wird absteigend nach der Anzahl der Hindernisse in der Gruppe sortiert, sodass Abstände, die sich im Flächenmodell häufig wiederholen, oben in der Tabelle stehen.

Die PlanerIn berücksichtigt vorliegend, dass einige der Solarelementmodelle 3 zu teuer sind und andere aufgrund ihrer ökologischen Bilanz ausscheiden und bildet daher im Verfahrensschritt E0 eine Untergruppe derjenigen Solarelementmodelle, die weiterhin in Frage kommen.

In Verfahrensschritt E wird für jedes Solarelementmodell der zuvor bestimmten Untergruppe das Eignungsmaß $EM_{SEi}$ berechnet. Das Eignungsmaß $EM_{SEi}$ hängt von den Solarelementabmessungen 5 und einem Abstand 6 ab. Vorliegend werden $n_{Abstände}=2$ Abstände 6 berücksichtigt. Dazu wird die Häufigkeitsverteilung der Abstände aus Verfahrensschritt D herangezogen und um die beiden am häufigsten auftretenden Abstände zu finden. Indem die Tabelle absteigend nach der Hindernisanzahl sortiert wurde, sind das hier die beiden obersten Einträge in der Tabelle.

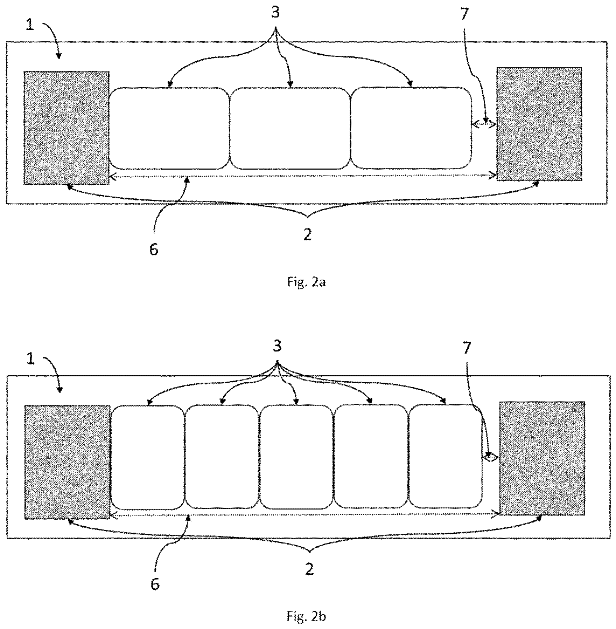

In den Figuren 2a und 2b ist gezeigt, wie sich verschiedene Solarelementabmessungen 5 innerhalb eines Abstands 6 zwischen zwei Hindernissen 2 verhalten. Es ist möglich, dass schlüssig aneinander gereihte Solarelemente 3 einen Abstand 6 gänzlich auffüllen, jedoch wird im Allgemeinen ein Restabstand 7 verbleiben. Das Eignungsmaß $EM_{SEi}$

$$EM_{SEi} = \frac{a_1}{L} + \frac{a_2}{n_{max}} + a_3 S$$

errechnet sich vorliegend aus . Dabei ist $L$ die Größe des Restabstands 7, der verbleibt, wenn im betrachteten Abstand die größtmögliche Anzahl von Solarelementen, $n_{max}$, angeordnet wird. $S$ bezeichnet die Gesamtfläche der angeordneten Solarelemente 3. $a_1$, $a_2$, $a_3$ sind Gewichtungsfaktoren für die einzelnen Summanden. Für $a_1 > a_2 = a_3$ wird beim Eignungsmaß $EM_{SEi}$ besonders derjenige Term gewichtet, der groß wird, wenn der Restabstand 7 klein ist. Im Ausführungsbeispiel wird nur der Restabstand 7 berücksichtigt, weshalb $a_1 = 1$, $a_2 = 0$, $a_3 = 0$ gewählt wird.

Der Verfahrensschritt E wird wiederholt, bis ein Abbruchkriterium erfüllt ist. Vorliegend betrifft das die Anzahl der zu berücksichtigenden Abstände, nämlich bis für jedes der Solarelementmodelle der Untergruppe das Eignungsmaß $EM_{SEi}$ für $n_{Abstände}=2$ Abstände 6 berechnet wurde.

In Verfahrensschritt F werden diejenigen Solarelementmodelle ausgewählt, die für jeden der berücksichtigten Abstände das größte Eignungsmaß $EM_{SEi}$ besitzen. Vorliegend betrifft das die beiden Abstände, die am häufigsten auftreten, was aus der Häufigkeitsverteilung entnommen wird.

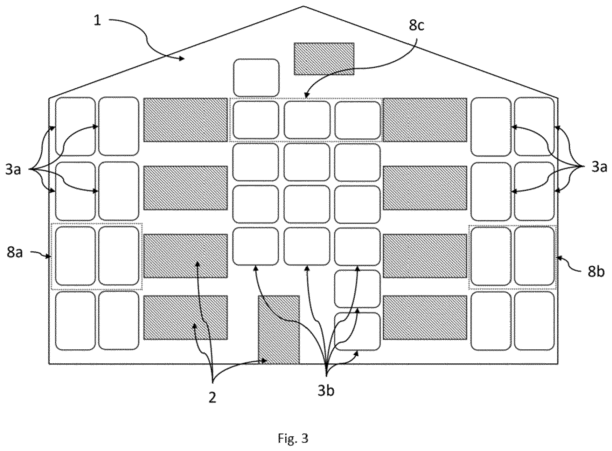

Mit diesen beiden Solarelementmodellen wird in einem Verfahrensschritt G ein Belegungsplan erstellt, indem mehrere Solarelemente 3 der ausgewählten Solarelementmodelle in den Abständen angeordnet werden. Das ist in Figur 3 schematisch gezeigt. Zuerst wird der am häufigsten vorkommende Abstand 6 in der Belegungsfläche 1 aufgefüllt mit Solarelementen 3 des entsprechenden Solarelementmodells. Dadurch wird für diesen Abstand 6 die Startreihe 8a gebildet. Ausgehend von jedem Solarelement 3 dieser Startreihe werden dazu in orthogonaler Richtung weitere Solarelemente 3 platziert, bis entweder ein weiteres Hindernis oder eine Begrenzung der Belegungsfläche 1 erreicht würde. Mit dem nächsthäufigen zu berücksichtigenden Abstand 6 wird analog verfahren, mit den Startreihen 8b und 8c. Dadurch entsteht ein streifenartiges Muster.

Bezugszeichenliste

1    Belegungsfläche
2    Hindernisse
3    Solarelemente
4    Endliche Menge von Solarelementmodellen
5    Solarelementabmessungen
6    Abstände
7    Restabstand
8    Startreihe

**Patentansprüche**

1. Verfahren zur Auswahl zumindest eines Solarelementmodells für einen Belegungsplan mit einer Mehrzahl von Solarelementen (3) auf einer Belegungsfläche (1), insbesondere einer Gebäudehülle, mit folgenden Verfahrensschritten:

   A Bereitstellen der Belegungsfläche (1) als Flächenmodell, welches Flächenmodell insbesondere Abmessungen der Belegungsfläche, Informationen zur Anordnung von Hindernissen (2) und/oder Informationen zu Spezialflächen mit besonderen Anforderungen beinhaltet;
   B Bereitstellen von Informationen zumindest hinsichtlich der Solarelementabmessungen (5) einer endlichen Menge von Solarelementmodellen;
   C Bestimmen von Abständen (6) zwischen benachbarten Hindernissen (2) und/oder zwischen einem Hindernis und der benachbarten Begrenzung der Belegungsfläche (1);
   D Erstellen einer Häufigkeitsverteilung der in Verfahrensschritt C bestimmten Abstände;
   E Berechnen eines Eignungsmaßes $EM_{SEi}$ eines Solarelementmodells für mehrere Solarelementmodelle aus der endlichen Menge von Solarelementmodellen, wobei das Eignungsmaß $EM_{SEi}$ basierend auf Abmessungen des Solarelementmodells in Bezug auf einen Abstand aus Verfahrensschritt C bestimmt wird;
   F Auswählen zumindest eines Solarelementmodells abhängig von dem Eignungsmaß $EM_{SEi}$

2. Verfahren zur Auswahl zumindest eines Solarelementmodells für einen Belegungsplan nach Anspruch 1, **dadurch gekennzeichnet,**

**dass** in einem Verfahrensschritt G ein Anordnen einer Mehrzahl Solarelemente (3) des ausgewählten Solarelementmodells als platzierbare Solarelemente (3) in dem Belegungsplan unter Berücksichtigung des Eignungsmaßes $EM_{SEi}$ erfolgt.

3. Verfahren zur Auswahl zumindest eines Solarelementmodells für einen Belegungsplan nach Anspruch 1 oder 2, **dadurch gekennzeichnet**, das Auswählen zumindest eines Solarelementmodells in Verfahrensschritt F bevorzugt abhängig von der Häufigkeitsverteilung erfolgt.

4. Verfahren zur Auswahl zumindest eines Solarelementmodells für einen Belegungsplan nach einem der vorangegangenen Ansprüche, **dadurch gekennzeichnet,** **dass** das Eignungsmaß $EM_{SEi}$ unter Berücksichtigung einer der folgenden Parameter berechnet wird:

- Restabstand L (7), der verbleibt, wenn eine maximale Anzahl $n_{max}$ von Solarelementen (3) desselben Solarelementmodells in einem der in Verfahrensschritt C bestimmten Abstände (6) aneinandergereiht platziert wird, bevorzugt, dass der Restabstand (7) antiproportional berücksichtigt wird, und/oder
- maximale Anzahl $n_{max}$ aneinandergereiht platzierbarer Solarelemente (3) eines Solarelementmodells in einem der in Verfahrensschritt C bestimmten Abstände (6) abhängt, bevorzugt, dass die maximale Anzahl platzierbarer Solarelemente (3) antiproportional berücksichtigt wird, und/oder
- Gesamtfläche S, die von $n_{max}$ aneinandergereihten Solarelementen (3) abgedeckt wird.

5. Verfahren zur Auswahl zumindest eines Solarelementmodells für einen Belegungsplan nach einem der vorangegangenen Ansprüche, **dadurch gekennzeichnet,**

**dass** das Eignungsmaß $EM_{SEi}$ sich wie folgt berechnet:

$$EM_{SEi} = a_1 \frac{1}{L} + a_2 \frac{1}{n_{max}} + a_3 S$$

oder

$$EM_{SEi} = \frac{1}{a_1 L + a_2 n_{max} + a_3 \frac{1}{S}},$$

wobei $a_1$, $a_2$, $a_3$ reelle Gewichtungsfaktoren sind, L der Restabstand (7), der verbleibt, wenn eine maximale Anzahl $n_{max}$ von Solarelementen (3) desselben Solarelementmodells in einem der in Verfahrensschritt C bestimmten Abstände (6) aneinandergereiht platziert wird, $n_{max}$ die maximale Anzahl aneinandergereiht platzierbarer Solarelemente (3) eines Solarelementmodells in einem der in Verfahrensschritt C bestimmten Abstände (6) und S die Gesamtfläche, die von $n_{max}$ aneinandergereihten Solarelementen (3) abgedeckt wird.

6. Verfahren zur Auswahl zumindest eines Solarelementmodells für einen Belegungsplan nach einem der vorangegangenen Ansprüche, **dadurch gekennzeichnet,** **dass** in einem Verfahrensschritt E0 vor dem Verfahrensschritt E aus der endlichen Menge von Solarelementmodellen eine Untergruppe definiert wird, vorzugsweise indem die Solarelementmodelle anhand wirtschaftlicher, ökologischer und/oder ästhetischer Gesichtspunkte bewertet werden, insbesondere bevorzugt, dass der Verfahrensschritt E für jedes Solarelementmodell der Untergruppe durchgeführt wird insbesondere bevorzugt, dass für jedes Solarelementmodell der Untergruppe das Eignungsmaß $EM_{SEi}$ für mehrere in Verfahrensschritt C bestimmte Abstände (6) berechnet wird.

7. Verfahren zur Auswahl zumindest eines Solarelementmodells für einen Belegungsplan nach einem der vorangegangenen Ansprüche, **dadurch gekennzeichnet,** **dass** in einem Verfahrensschritt F0 vor dem Verfahrensschritt F für jedes Solarelementmodell der Untergruppe ein gewichteter Mittelwert der Eignungsmaße $EM_{SEi}$ des Solarelementmodells berechnet wird, wobei die Gewichtung anhand der Häufigkeitsverteilung aus Verfahrensschritt D erfolgt.

8. Verfahren zur Auswahl zumindest eines Solarelementmodells für einen Belegungsplan nach einem der Ansprüche 2 bis 7,

   **dadurch gekennzeichnet,**

   **dass** das Solarelementmodell mit dem höchsten gewichteten Mittelwert des Eignungsmaßes $EM_{SEi}$ als ausgewähltes Solarelementmodell bestimmt wird und der Belegungsplan in Verfahrensschritt G derart erstellt wird, dass die maximale Anzahl platzierbarer Solarelemente (3) des ausgewählten Solarelementmodells als Startreihe (8) zwischen zwei horizontal benachbarten Hindernissen (2) angeordnet wird und bevorzugt über und/oder unter der Startreihe (8) weitere Reihen von platzierbaren Solarelemente (3) des ausgewählten Solarelementmodells angeordnet werden bis zu einem vertikal nächstliegenden Hindernis (2),
   oder,
   **dass** die maximale Anzahl platzierbarer Solarelemente (3) des ausgewählten Solarelementmodells als Startreihe (8) zwischen zwei vertikal benachbarten Hindernissen (2) angeordnet wird und bevorzugt in horizontaler Richtung rechts oder links der Startreihe (8) weitere Reihen von platzierbaren Solarelemente (3) des ausgewählten Solarelementmodells angeordnet werden bis zu einem horizontal nächstliegenden Hindernis (2).

9. Verfahren zur Auswahl zumindest eines Solarelementmodells für einen Belegungsplan nach einem der Ansprüche 2 bis 8,

   **dadurch gekennzeichnet,**

   **dass** der Belegungsplan in Verfahrensschritt G derart erstellt wird, dass für mehrere der in Verfahrensschritt C bestimmten Abstände das Solarelementmodell mit dem dafür höchsten Eignungsmaß $EM_{SEi}$ ausgewählt wird.

10. Verfahren zur Auswahl zumindest eines Solarelementmodells für einen Belegungsplan nach einem der vorangegangenen Ansprüche,

    **dadurch gekennzeichnet,**

    **dass** eine maximale Anzahl von Abständen $n_{Abstände}$ vorgebbar ist, die in Verfahrensschritt E berücksichtigt werden.

11. Verfahren zur Auswahl zumindest eines Solarelementmodells für einen Belegungsplan nach einem der vorangegangenen Ansprüche,

    **dadurch gekennzeichnet,**

    **dass** eine maximale Anzahl unterschiedlicher Solarelementmodelle vorgebbar ist, die bei der Erstellung des Belegungsplans berücksichtigt werden.

12. Verfahren zur Auswahl zumindest eines Solarelementmodells für einen Belegungsplan nach einem der vorangegangenen Ansprüche,

    **dadurch gekennzeichnet,**

    **dass** der Verfahrensschritt E wiederholt wird, und die Wiederholung abgebrochen wird, wenn zumindest eine der folgenden Abbruchbedingungen erfüllt ist:

    - die maximale Anzahl von unterschiedlichen Solarelementmodellen ist erreicht;
    - der vorgebbare Wert $n_{Abstände}$ für die Anzahl zu berücksichtigender Abstände ist erreicht;
    - eine Differenz $\Delta_{EM,inkrementell}$ zwischen dem Eignungsmaß des in Schritt j bestimmten j-ten Solarelementmodells $EM_{SE,Schritt\,j}$ und dem Eignungsmaß der letzten Wiederholung des Verfahrensschrittes E $EM_{SE,Schritt\,(j-1)}$ ist kleiner als eine vorgebbare Mindestdifferenz $\Delta_{EM,inkrementell,min}$;
    - eine Differenz $\Delta_{EM,gesamt}$ zwischen dem Eignungsmaß des in Schritt j bestimmten j-ten Solarelementmodells $EM_{SE,Schritt\,j}$ und dem Eignungsmaß $EM_{SE,Schritt\,1}$ der ersten Wiederholung des Verfahrensschrittes E ist größer als eine vorgebbare Maximaldifferenz $\Delta_{EM,gesamt,max}$.

13. Verfahren zur Auswahl zumindest eines Solarelementmodells für einen Belegungsplan nach einem der vorangegangenen Ansprüche,

    **dadurch gekennzeichnet,**

    **dass** eine Differenz $\Delta_{EM}$ zwischen dem Eignungsmaß $EM_{SEi}$ des Solarelementmodells mit der größten Häufigkeit und dem $EM_{SEj}$ jedes Solarelementmodells j der Untergruppe berechnet wird.

14. Computerprogramm mit Anweisungen, die, wenn das Programm von einem Computer ausgeführt wird, den Computer veranlassen, das Verfahren nach einem der Ansprüche 1 bis 13 auszuführen.

15. Computerlesbares Medium mit Befehlen, die, wenn sie von einem Computer ausgeführt werden, den Computer veranlassen, das Verfahren nach einem der Ansprüche 1 bis 13 auszuführen.

Fig. 1a

Fig. 1b

Fig. 2a

Fig. 2b

Fig. 3

Europäisches
Patentamt

European
Patent Office

Office européen
des brevets

# EUROPÄISCHER RECHERCHENBERICHT

Nummer der Anmeldung

EP 24 18 0785

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | US 2014/289168 A1 (WAYNE GARY [US] ET AL) 25. September 2014 (2014-09-25) <br> * Absatz [0023] - Absatz [0081] * <br> * Absatz [0102] - Absatz [0107] * <br> * Abbildungen 4-6 * <br> ----- | 1-15 | INV. <br> G06F30/13 |
| X | US 2014/025343 A1 (GREGG DAVID CHARLES [US] ET AL) 23. Januar 2014 (2014-01-23) <br> * Absatz [0005] - Absatz [0007] * <br> * Absatz [0035] - Absatz [0069] * <br> ----- | 1-15 | |
| A | US 2012/330759 A1 (AGGARWAL VIKRAM [US] ET AL) 27. Dezember 2012 (2012-12-27) <br> * Absatz [0068] - Absatz [0155] * <br> ----- | 1-15 | |

RECHERCHIERTE SACHGEBIETE (IPC)

G06F

Der vorliegende Recherchenbericht wurde für alle Patentansprüche erstellt

| Recherchenort | Abschlußdatum der Recherche | Prüfer |
|---|---|---|
| München | 14. November 2024 | Kraska, Nora |

EPO FORM 1503 03.82 (P04C03)

**ANHANG ZUM EUROPÄISCHEN RECHERCHENBERICHT
ÜBER DIE EUROPÄISCHE PATENTANMELDUNG NR.**

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

14-11-2024

| Im Recherchenbericht angeführtes Patentdokument | Datum der Veröffentlichung | Mitglied(er) der Patentfamilie | Datum der Veröffentlichung |
|---|---|---|---|
| US 2014289168 A1 | 25-09-2014 | KEINE | |
| US 2014025343 A1 | 23-01-2014 | KEINE | |
| US 2012330759 A1 | 27-12-2012 | AU 2012271854 A1 | 30-01-2014 |
| | | CA 2841423 A1 | 20-12-2012 |
| | | US 2012330759 A1 | 27-12-2012 |
| | | WO 2012174010 A2 | 20-12-2012 |

EPO FORM P0461

Für nähere Einzelheiten zu diesem Anhang : siehe Amtsblatt des Europäischen Patentamts, Nr.12/82